(19) Europäisches Patentamt
European Patent Office
Office européen des brevets

(11) EP 1 717 290 A1

(12) EUROPEAN PATENT APPLICATION
published in accordance with Art. 158(3) EPC

(43) Date of publication:
**02.11.2006 Bulletin 2006/44**

(21) Application number: **05710144.6**

(22) Date of filing: **04.02.2005**

(51) Int Cl.:
***C09K 11/06*** *(2006.01)* ***H01L 33/00*** *(2006.01)*

(86) International application number:
**PCT/JP2005/002092**

(87) International publication number:
**WO 2005/075598 (18.08.2005 Gazette 2005/33)**

(84) Designated Contracting States:
**DE**

(30) Priority: **06.02.2004 JP 2004030173**

(71) Applicant: **MITSUBISHI CHEMICAL CORPORATION**
**Tokyo 108-0014 (JP)**

(72) Inventors:
- **YABE, Akiko,**
**c/o Mitsubishi Chemical Corporation**
**Yokohama-shi,**
**Kanagawa 2278502 (JP)**
- **MURAYAMA, Tetsuo,**
**c/o Mitsubishi Chemical Corp.**
**Yokohama-shi,**
**Kanagawa 2278502 (JP)**

(74) Representative: **Vossius & Partner**
**P.O. Box 86 07 67**
**D-81634 München (DE)**

# (54) LIGHT EMITTING DEVICE AND LIGHTING DEVICE USING IT, IMAGE DISPLAY UNIT

(57) An object of the present invention is to provide a light emitting device which is high in emission intensity and stable, that is to say, a light emitting device in which when an LED or LD having an emission peak at 380 nm to 410 nm is used as an excitation light source of the light emitting device, the emission intensity of a red phosphor does not largely change to some deviation of the emission wavelength of the LED or LD to maintain not only brightness but also a balance at the time when mixed with a blue and green phosphors.

The present invention relates to a light emitting device **characterized in that** the device comprises a phosphor which has $Eu^{3+}$ as a luminescent center ion, in which a minimum emission intensity within the excitation wavelength range of 380 nm to 410 nm in an excitation spectrum is 65% or more of a maximum emission intensity, and which has an emission efficiency at 400 nm of 20% or more, and a semiconductor light emitting element which emits light in the region from near-ultraviolet light to visible light.

EP 1 717 290 A1

## Description

Technical Field

The present invention relates to a light emitting device, a lighting system and an image display unit, and more particularly to a light emitting device in which a semiconductor light emitting element is combined with a red phosphor, a lighting system using the same, and an image display unit.

Background Art

Light emitting devices in which light of a discharge lamp or a semiconductor light emitting element is color converted with a phosphor have hitherto been used in lighting systems and display units. These light emitting devices emit white or any color light by mixing blue, green and red phosphors, and various studies have recently been made in pursuit of higher color rendering properties or color reproducibility. Above all, light emitting devices using a semiconductor light emitting element such as a light emitting diode (LED) or a semiconductor laser (LD) have high luminous efficiency and also contain no hazardous substance such as mercury. Accordingly, the development of light emitting devices in which the LED or the LD is combined with the phosphor, particularly the high efficient LED or LD in the region from near-ultraviolet light of 370 nm or more to visible light has been actively carried out.

However, the red phosphor such as $Y_2O_2S$:Eu mainly used in the light emitting device at present has the problem of a significant decrease in emission efficiency when light in the region from near-ultraviolet light to visible light is used as an excitation source, because absorption at a wavelength of 360 nm or more in the near-ultraviolet region is small.

As improvements of these problems, there have been reported phosphors which are excitable at higher efficiency in the near-ultraviolet region, for example, $La_2O_2S$:Eu (KX-680 manufactured by Kasei Optonix Ltd.), $LiEuW_2O_8$ described in JP-A-2003-4152 and the like. On the other hand, it has been known that a fluorescent complex having $Eu^{3+}$ emits a sharp red color at high efficiency, and the excitation wavelength can be adjusted by a suitable selection of ligand. Accordingly, there has also been reported a light emitting device in which the fluorescent complex is combined with the LED or LD as the red phosphor. For example, according to WO02/91487, there has been reported an Eu complex derived from the f-f transition of $Eu^{3+}$ and showing high excitation efficiency at a specified wavelength in the near-ultraviolet region. Further, according to JP-A-2003-81986, there has been reported a light emitting material containing a high-efficiency $Eu^{3+}/\beta$-diketone complex and also excitable at 400 nm or more in the visible region.

However, an excitation spectrum of the above-mentioned red phosphor shows a sharp change at 380 nm to 410 nm which is in the region from near-ultraviolet light to visible light. On the other hand, the LED or LD is difficult to stably produce the emission wavelength with a high degree of accuracy, and in addition, the emission wavelength also shifts by a change in temperature or current to deviate $\pm 5$ nm from the center wavelength in some cases. Accordingly, when the LED or LD having an emission peak at 380 nm to 410 nm is used as the excitation light source for the above-mentioned red phosphor, the emission intensity of the red phosphor largely changes to a deviation of the emission wavelength thereof to vary not only brightness but also a balance at the time when mixed with the blue and green phosphors, also resulting in changes in chromaticity and color temperature of a color-converted emission color.

Further, according to USP 6, 366, 033 B1, there has been reported an $Eu^{3+}/\beta$-diketone complex showing an excitation spectrum small in the rate of change in the region from near-ultraviolet light to visible light. However, although the emission intensity caused by absorption of ligand in a high-efficiency $Eu^{3+}/\beta$-diketone complex is generally sufficiently high compared to the emission intensity of 465 nm excitation derived from the f-f transition of $Eu^{3+}$, the maximum emission intensity obtained in the $Eu^{3+}/\beta$-diketone complex in the above-mentioned patent is only about twice the emission intensity of 465 nm excitation. The emission intensity is therefore insufficient in considering a balance with the blue and green phosphors.

Accordingly, the development of a red phosphor which does not largely change in light emission characteristics to a change in wavelength of the LED or LD, and has high emission intensity has been desired. In the case of white light or any color light emission, the respective phosphors have been demanded to have sufficient emission intensity, and chromaticity and spectrum characteristics for allowing mixed ones to show high color reproducibility as a whole. Further, it has been desired that the emission output and chromaticity do not change by variations in wavelength of the LED or LD.

[Patent Document 1]
JP-A-2003-4152
[Patent Document 2]
WO 02/91487
[Patent Document 3]
JP-A-2003-81986
[Patent Document 4]

USP 6,366,033 B1

Disclosure of the Invention

The present invention has been made in order to solve the above-mentioned problems of conventional art, and an obj ect thereof is to develop a red phosphor highly efficient to excitation light of 380 nm to 410 nm which is in the region from near-ultraviolet light to visible light, thereby providing a light emitting device high in emission intensity and excellent in color reproducibility and a lighting system using the same, and an image display unit.

In order to solve the above-mentioned problem, the present inventors have made intensive studies. As a result, it has been found that although $Eu^{3+}$ generally has relatively high emission efficiency to excitation light in the ultraviolet region of 350 nm or less by energetic constraints, excitation in a longer wavelength region becomes possible by properly selecting the environment around $Eu^{3+}$. Then, it has been found that a red phosphor which high-efficiently emits red light by excitation light in the region from near-ultraviolet light to visible light and has emission intensity stable to a deviation of excitation wavelength is obtained by improving characteristics relating to excitation energy, that is to say, properly selecting the environment of an intermolecular interaction of the excitation energy, with respect to a red phosphor having $Eu^{3+}$ as a luminescent center, particularly with respect to a fluorescent complex.

Accordingly, the present inventors have found that the above-mentioned object is achieved by a light emitting device characterized in that the device comprises a red phosphor which has $Eu^{3+}$ as a main luminescent center ion, has a small difference between a minimum emission intensity and a maximum emission intensity within the excitation wavelength range of 380 nm to 410 nm in an excitation spectrum, and high-efficiently emits light for excitation light in the region from near-ultraviolet light to visible light, particularly for excitation light of approximately 400 nm, and a semiconductor light emitting element which emits light in the region from near-ultraviolet light to visible light, thus attaining the present invention.

That is to say, the gist of the present invention is in a light emitting device which comprises a phosphor and a semiconductor light emitting element, wherein the phosphor has $Eu^{3+}$ as a luminescent center ion, wherein a minimum emission intensity of the phosphor within the excitation wavelength range of 380 nm to 410 nm in an excitation spectrum is 65% or more of a maximum emission intensity, and wherein the phosphor has an emission efficiency at 400 nm of 20% or more, and wherein the semiconductor light emitting element emits light in the region from near-ultraviolet light to visible light, a lighting system comprising the same and an image display unit.

As the mechanism of light emission of a rare earth element ion complex, there is known the mechanism that the ligand absorbs light from a light emitter and excitation energy thereof transfers to a rare earth ion to excite the ion, thereby emitting light. When the excitation energy level of the ligand is too low, compared to excitation energy of the rare earth ion, energy transfer does not occur, resulting in failure to emit light. For example, in the case of an $Eu^{3+}$ complex used in the red phosphor, the ligand goes into an excited singlet (S1) state on absorption of light, and intersystem crossing is carried out therefrom to an excited triplet ($T_1$) state. Then, energy transfer is performed from the $T_1$ state to an excited state ($^5D_1$) of $Eu^{3+}$. Transition from $^5D_0$ of $Eu^{3+}$ to $^7F_2$ has been considered to cause the main component to emit red light (see Fig. 1). In order to examine the effect of energy in the triplet state in such an energy transfer mechanism, there has been reported a study in which triplet energy ($T_1$) of a ligand molecule and light emission of an Eu complex and a terbium ion ($Tb^{3+}$) complex are measured and the relationship therebetween is discussed (document-1: Susumu Sato and Masanobu Wada, Bulletin of The Chemical Society of Japan, Vol. 43, 1955-1962 (1970)).

In this paper, the relationship between triplet energy of various aromatic group containing β-diketones and excited state energy of an europium ion and a terbium ion, and the occurrence or no occurrence of light emission have been examined, and it has been reported that the triplet energy level of ligand is related to light emission. It is described that a complex in which the triplet energy of the ligand is lower than the energy level in the excited state of the rare earth ion does not emit light.

In these compounds, an absorption spectrum of a complex molecule approximately agrees with that of the ligand. However, when these compounds are in a state in which an intermolecular interaction is possible, absorption characteristics thereof do not necessarily agree with those in a molecular state, that is to say, in a dilute solution state, and a shift of an absorption peak to a longer wave length and enlargement of the spectrum width are observed. The absorption peak value and absorption form of the absorption spectrum depend on the state of the intermolecular interaction and the surrounding environmental state, and the excitation spectrum becomes flat and broad in width by obtaining the sufficiently broad absorption spectrum. In addition, in some state of the intermolecular interaction, the excitation energy absorbed by the ligand has been known to transfer between molecules, different from the case of the molecular state. Regarding the transfer state of this excitation energy as transfer of a particle, this particle is also referred to as an exciton. Transfer of the exciton also occurs in a film of a polymer having on a side chain or a main chain a molecular unit which absorbs light, or in a solid solution in which the molecule has been dissolved in a binder resin.

In the case of a rare earth ion complex molecule used in the present invention, the exciton which transfers between the complex molecules performs energy transfer from the ligand to the rare earth ion to emit light, when it has

arrived at a certain complex molecule. When the exciton is deactivated by impurities, a crystal defect, an energy trap or the like in the course of this transfer, the number of the excitons contributing to light emission decreases to shorten the exciton life, resulting in a decrease in emission efficiency. Consequently, in order to enhance the emission efficiency, it is necessary to remove the impurities, or to select the optimum ligand or the environment such as a crystalline state. Even for the same compound, the emission intensity is significantly different in some cases depending on the surrounding environmental state.

According to the present invention, there can be provided a light emitting device which is stable and high in emission intensity.

Brief Description of the Drawings

Fig. 1 is a view showing a light emitting mechanism of an $Eu^{3+}$ complex used in a red phosphor.
Fig. 2 is a view showing an example of a light emitting device of the present invention.
Fig. 3 shows excitation spectra of Example 6 and Comparative Example 7.
Fig. 4 is a powder X-ray diffraction pattern of a compound of Example 2.
Fig. 5 is a powder X-ray diffraction pattern of a compound of Comparative Example 2.
Fig. 6 shows excitation spectra of Example 2 and Comparative Example 2.
Fig. 7 shows excitation spectra of Example 7 and Comparative Example 1.

As for reference numerals in the figure, 10 indicates a light emitting device, 11 indicates a semiconductor light emitting element, 12 indicates a phosphor layer, 13 indicates an external cap, 14a indicates an inert gas, 14b indicates an ultraviolet absorbing layer, 15a and 15b indicate conductive wires, 16a indicates an inner lead, 16b indicates a mount lead, 17 indicates a sealing resin portion, 18 indicates a blanket, and 19 indicates an electric contact.

Best Mode for Carrying Out the Invention

The illustration of constituent features described below is one example of embodiments of the present invention, and the invention is not specified by these contents.

A phosphor used in the present invention is a phosphor which has $Eu^{3+}$ as a main luminescent center ion, in which a minimum emission intensity within the excitation wavelength range of 380 nm to 410 nm in an excitation spectrum thereof is 65% or more of a maximum emission intensity, and which has an emission efficiency at 400 nm of 20% or more. This phosphor usually emits red light.

Further, in terms of increasing the emission intensity of the phosphor, in the excitation spectrum, the maximum emission intensity is preferably 3 times or more the intensity of a peak around 465 nm which is in an excitation band of the f-f transition of $Eu^{3+}$. The intensity $Y_{(ff)}$ of a peak around 465 nm which is in an excitation band of the f-f transition of $Eu^{3+}$ is found from values of emission intensities $Y_{(x-2)}$ and $Y_{(x+2)}$ in (x-2) nm and (x+2) nm, when the wavelength of its peak top is taken as x and the emission intensity at that time is taken as $Y_{(x)}$, by the following equation:

$$Y_{(ff)} = Y_{(x)} - \frac{Y_{(x-2)} + Y_{(x+2)}}{2}$$

The above-mentioned phosphor is not particularly limited as long as characteristics as described above are obtained, and may be either an organic compound or an inorganic compound. However, typically, the organic compound is preferred. Above all, a fluorescent complex is preferred. The fluorescent complex is preferably a complex having an aromatic ring or a heteroaromatic ring in a ligand, because excitation at a longer wavelength becomes possible, more preferably a β-diketonate complex or an aromatic carboxylic acid complex, and still more preferably a β-diketonate complex. The β-diketonate complex will be described below.

The β-diketonate complex is represented by general formula Eu (β-diketonate) $_3L_n$, and is a complex having as a ligand a β-diketonate anion derived from a β-diketone compound. L is a neutral ligand which is unidentate or multidentate, and n is 1 or 2.

The β-diketone compound from which the β-diketonate anion is derived is not particularly limited. However, in terms of an excitation wavelength region, it is preferred to have a β-diketone structure and at least one aromatic ring or

aromatic heterocycle (hereinafter referred to as an aromatic group) as a substituent group, which may have a substituent group, in its structure. As for a method for connecting the β-diketone structure and the aromatic group, they may be connected directly or by a divalent group. However, it is preferred that the aromatic group is directly connected to at least one ketone.

The aromatic rings include, for example, aromatic monocyclic hydrocarbons or aromatic condensed polycyclic hydrocarbons such as benzene, naphthalene, phenanthrene, indene, biphenylene, acenaphthene, fluorene, tetralin and indan. The aromatic heterocycles include aromatic monocyclic heterocycles or aromatic condensed polycyclic heterocycles such as furan, pyrrole, thiophene, oxazole, isoxazole, thiazole, imidazole, pyridine, benzofuran, dibenzofuran, benzothiophene, dibenzothiophene, benzopyran, carbazole, xanthene, quinoline and triazine.

The substituent groups of the aromatic ring or the aromatic heterocycle include an alkyl group such as methyl, ethyl, propyl or butyl; a fluoroalkyl group such as trifluoromethyl or pentafluoroethyl; an ethynyl group; an arylethynyl group such as phenylethynyl, pyridylethynyl or thienylethynyl; an alkoxy group such as methoxy or ethoxy; an aryl group such as phenyl or naphthyl; an aralkyl group such as benzyl or phenethyl; an aryloxy group such as phenoxy, naphthoxy or biphenyloxy; a hydroxyl group; an allyl group; an acyl group such as acetyl, propionyl, benzoyl or toluoyl; an acyloxy group such as acetoxy, propionyloxy or benzoyloxy; an alkoxycarbonyl group such as methoxycarbonyl or ethoxycarbonyl; an aryloxycarbonyl group such as phenoxycarbonyl; a carboxyl group; a carbamoyl group; an amino group; a substituted amino group such as dimethylamino, diethylamino, methylbenzylamino, diphenylamino or acetyl-methylamino; a substituted thio group such as methylthio, ethylthio, phenylthio or benzylthio; a mercapto group; a substituted sulfonyl group such as ethylsulfonyl or phenylsulfonyl; a cyano group; a halogen group such as fluoro, chloro, bromo or iodo; and the like. These substituent groups may combine with each other to form a ring.

The substituent groups other than the aromatic groups, which constitute the β-diketone compounds, include the same substituent groups (with the exception of halogen groups) as the above-mentioned substituent groups of the aromatic ring or the aromatic heterocycle.

Specific examples of the β-diketone compounds from which the β-diketonate anion is derived are shown below, but the present invention is not limited to these compounds.

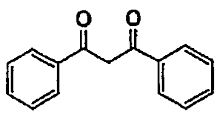

1

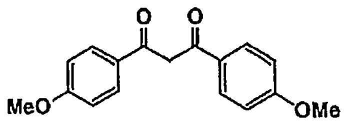

2

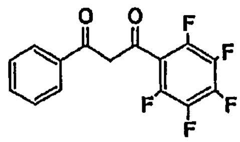

3

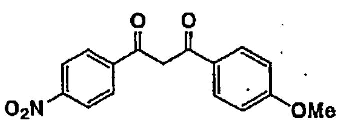

4

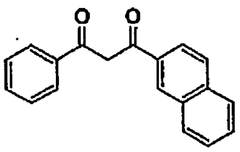

5

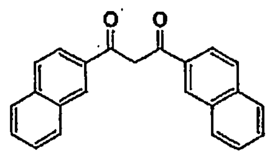

6

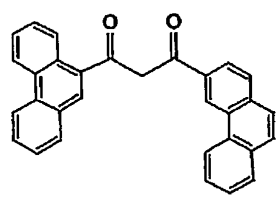

7

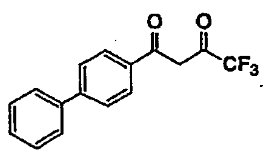

8

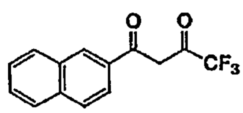

9

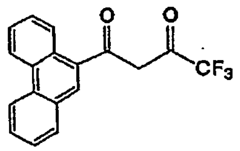

10

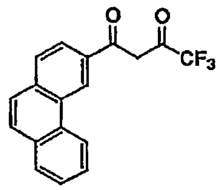

11

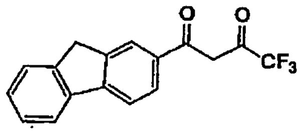

12

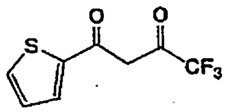

13

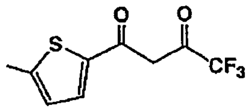

14

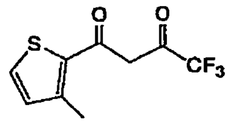

15

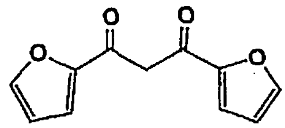

16

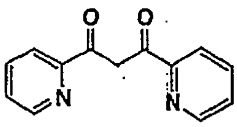

17

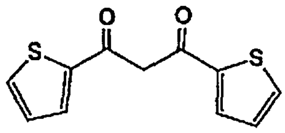

18

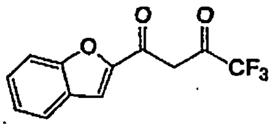

19

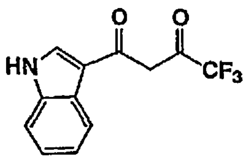

20

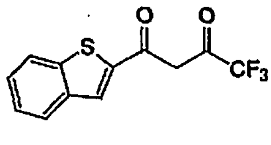

21

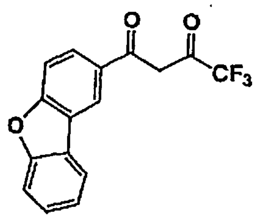

22

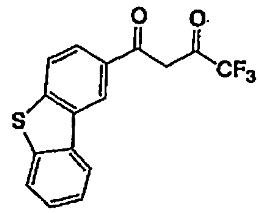

23

Although the neutral ligand L is not particularly limited, it is a compound having N and O atoms, which is coordinatable to $Eu^{3+}$. Examples thereof include an amine, an amine oxide, a phosphine oxide, a ketone, a sulfoxide, an ether and the like. These are selected alone or in combination so that total coordination number to $Eu^{3+}$ becomes 7 or 8.

For the neutral ligand L, for example, the amines include pyridine, pyrazine, quinoline, isoquinoline, 2,2'-bipyridine, 1, 10-phenanthroline and the like which may have a substituent group. The amine oxides include N-oxides of the above-mentioned amines such as pyridine-N-oxide, isoquinoline-N-oxide, 2,2'-bipyridine-N,N'-dioxide and 1,10-phenanthroline-N,N' -dioxide which may have a substituent group. The phosphine oxides include alkylphosphine oxides such as triphenylphosphine oxide, triethylphosphine oxide and trioctylphosphine oxide which may have a substituent group, 1,2-ethylenebis(diphenylenephosphine oxide), (diphenylphosphonimide)triphenylphosphorane triphenyl phosphate and the like. The ketones include dipyridylketone, benzophenone and the like which may have a substituent group, and the sulfoxides include diphenyl sulfoxide, dibenzyl sulfoxide, dioctyl sulfoxide and the like which may have a substituent group. The ethers include ethylene glycol dimethyl ether, diethylene glycol dimethyl ether and the like which may have a substituent group.

Further, as the substituent groups to be substituted to these, there are exemplified the substituent groups described above.

Specific examples of the neutral ligands L are exemplified below, but the present invention should not be construed as being limited thereto.

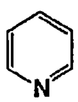
1

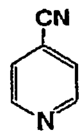
2

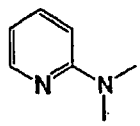
3

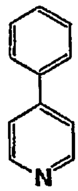
4

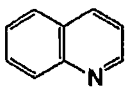
5

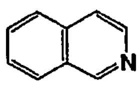
6

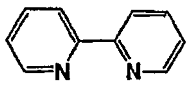
7

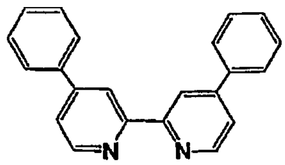
8

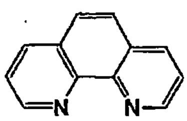
9

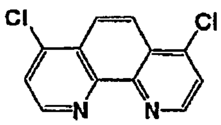
10

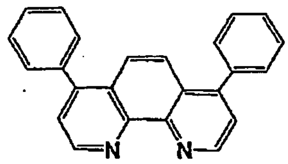
11

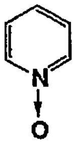
12

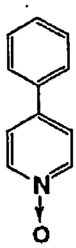
13

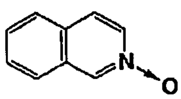
14

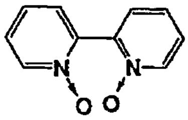
15

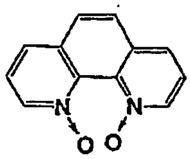
16

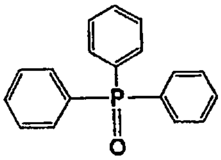
17

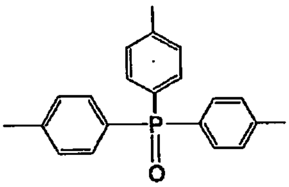
18

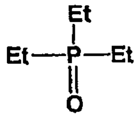
19

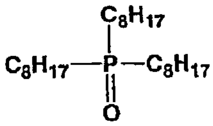
20

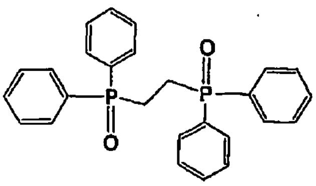
21

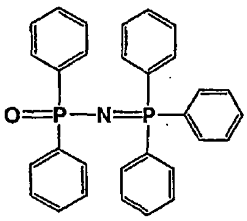
22

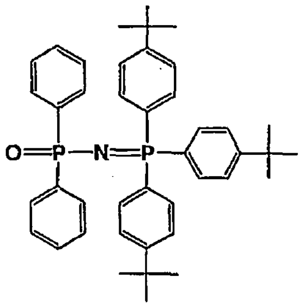
23

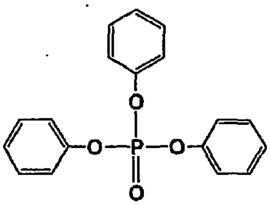
24

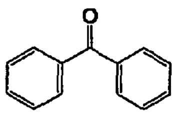
25

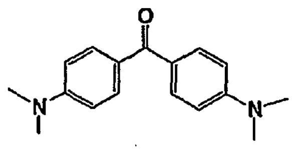
26

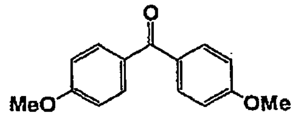
27
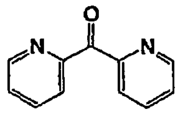
28
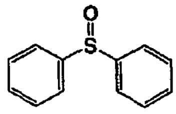
29
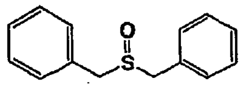
30

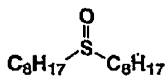
31
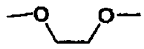
32
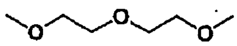
33

Although the phosphor used in the present invention has $Eu^{3+}$ as a luminescent center ion, it may contain another metal within the range that does not impair light emission characteristics thereof. Although the metal which may be contained is not particularly limited, examples thereof include Y, Gd, La, Lu, Tb and the like.

Further, the phosphor is not particularly limited, as long as physical properties defined in the present invention are obtained. However, it is not necessarily specified only by the kind of compound, and the physical properties of the present invention can be achieved in some cases by a crystal structure. The difference in crystal structure can be distinguished, for example, by the difference in melting points, X-ray diffraction peaks or the like.

For example, β-diketonate complex $Eu(\beta\text{-diketonate})_3L_n$ can be generally produced by reacting europium chloride, a β-diketone compound, a neutral ligand and a base at a molar ratio of 1:3:n:3. However, the resulting β-diketonate complex is sometimes different in crystal complex depending on its production method, so that even for the same compound, light emission characteristics are different in some cases. It is therefore necessary to properly select reaction conditions such as the base species, reaction solvent, reaction temperature, reaction concentration and reaction time depending on the compound. Although one cannot make that kind of sweeping generalization, because it also depends on the kind of complex, examples thereof include slowing down the rate of formation of the complex, specifically slowing down the rate of addition of the raw materials or controlling the kind or amount of solvent to adjust the solubility of the complex formed, thereby slowing down the rate of crystallization, and the like.

Specifically, in the case of a 7-coordinate type europium (III) complex represented by the following formula (a), which has a dibenzoylmethane anion (D) as a ligand and triphenylphosphine oxide (T) as an auxiliary ligand, the physical properties of the present invention are achieved, for example, when the crystal structure is in a state shown below, though not limited to the following.

$$D_3EuT \qquad (a)$$

(Crystal Structure)

Crystal system; triclinic system
Space group; P1
Lattice constants; a=12.3±1 angstroms, b=18.7±1 angstroms, c=11.5±1 angstroms, α=95.8±2°, β=103.1±2°, γ=87.8±2°

In the case of this complex, the complex which forms the above-mentioned crystal structure can be obtained by controlling the rate of crystallization of the complex. However, when the rate of crystallization is not proper, the complex formed becomes an amorphous solid or a state containing different crystal forms, resulting in a tendency of emission intensity to decrease.

Reaction solvents include alcohols such as methanol, ethanol, propanol and isopropanol, ketones such as acetone and methyl ethyl ketone, tetrahydrofuran, acetonitrile and mixed solvents thereof, or mixed solvents thereof with water. However, preferred are alcohols, and particularly preferred are ethanol, isopropanol and mixed solvents thereof with water.

The reaction concentration and reaction temperature are not particularly limited, as long as they are within the range that dissolves reaction substrates in the above-mentioned reaction solvent. However, they are adjusted to such

a degree that the complex can be precipitated in a crystalline state. The resulting crystalline complex may be subjected to a purification operation, but it has sufficient fluorescence emission intensity, even when it is not particularly subjected thereto.

The crystalline complex having the above-mentioned crystal structure can also be produced by recrystallization from the complex obtained in an amorphous state or in a state containing different crystal forms.

Further, in the case of an 8-coordinate type europium (III) complex represented by the following formula (b), which has a 2- thenoyltrifluoroacetone anion (A) as a ligand and 1, 10-phenanthroline (P) as an auxiliary ligand, the physical properties of the present invention are achieved, for example, when the crystal structure is in a state shown below, though not limited to the following.

$$A_3EuP \qquad (b)$$

(Crystal Structure)

Crystal system; triclinic system
Space group; P1
Lattice constants; a=13.2±1 angstroms, b=15.2±1 angstroms, c=9.7±1 angstroms, α=92.5±2°, β=102.6±2°, γ=91.6±2°

In the case of this complex, the complex which forms the above-mentioned crystal structure can be obtained by controlling the rate of crystallization of the complex. However, when the rate of crystallization is not proper, the complex formed becomes an amorphous solid or a state containing different crystal forms, resulting in a tendency of emission intensity to decrease.

Reaction solvents include alcohols such as methanol, ethanol, propanol and isopropanol, ketones such as acetone and methyl ethyl ketone, tetrahydrofuran, acetonitrile and mixed solvents thereof, or mixed solvents thereof with water. However, preferred are alcohols, and particularly preferred are ethanol and isopropanol.

The reaction concentration and reaction temperature are not particularly limited, as long as they are within the range that dissolves reaction substrates in the above-mentioned reaction solvent. However, they are adjusted to such a degree that the complex can be precipitated in the above-mentioned crystal form state. The resulting crystalline complex may be subjected to a purification operation, but it has sufficient fluorescence emission intensity, even when it is not particularly subjected thereto.

The crystalline complex having the above-mentioned crystal structure can also be produced by recrystallization from the complex obtained in an amorphous state or in a state containing different crystal forms.

With respect to the emission efficiency of the phosphor used in the present invention, methods for obtaining the quantum absorption efficiency $\alpha q$ and the inner quantum efficiency $\eta i$ are described below. First, a cell is filled with a phosphor sample to be measured which has been converted to a powder form or the like, with a surface sufficiently smoothed so that the measurement accuracy is maintained, and attached to a spectrophotometer having an integrating sphere. As this spectrophotometer, there is, for example, MCPD7000 manufactured by Otsuka Electronics Co., Ltd., or the like. The reason for the use of the integrating sphere and the like is due to making it possible to add up all of photons reflected at the sample and photons discharged from the sample by photoluminescence, that is to say, due to preventing photons from flying away from a measurement system without being added up. This spectrophotometer is equipped with a light emission source for exciting the phosphor. This light emission source is, for example, a Xe lamp or the like, and adjusted to an emission peak wavelength of 400 nm with a filter or the like. The sample to be measured is irradiated with light from the light emission source adjusted so as to have an emission peak wavelength of 400 nm, and an emission spectrum thereof is measured. In this measured spectrum, in addition to the photons discharged from the sample by photoluminescence by the light from the excitation light emission source (hereinafter briefly referred to as excitation light), contribution of the photons of the excitation light reflected at the sample is actually overlapped. The absorption efficiency $\alpha q$ is the value of the photon number Nabs of the excitation light absorbed by the sample divided by the total photon number N of the excitation light. First, the latter total photon number N of the excitation light is found as described below. That is to say, a material having a reflectance R of approximately 100% to the excitation light, for example, a reflecting plate such as Spectralon (having a reflectance of 98% to the excitation light at 400 nm) manufactured by Labsphere, is attached as a subject to be measured to the spectrophotometer, and a reflection spectrum Iref(λ) is measured. The numerical value determined herein from this reflection spectrum Iref(λ) by (equation 1) is proportional to N.

$$[(1/R)\int\lambda]\cdot I_{ref}(\lambda)\,d\lambda \qquad \text{(equation 1)}$$

As for the integration zone used herein, integration may be substantially performed only in a zone in which Iref ($\lambda$) has a significant value. For example, it is sufficient to take within the range of 370 nm to 420 nm. The former Nabs is proportional to an amount found by (equation 2).

$$[(1/R)\int\lambda]\cdot I_{ref}(\lambda)\,d\lambda-\int\lambda\cdot I(\lambda)\,d\lambda \qquad \text{(equation 2)}$$

At this time, I($\lambda$) is a reflection spectrum at the time when the subject sample for which $\alpha q$ is intended to be found is attached. The integration range of (equation 2) is conformed to the integration range defined in (equation 1). By limiting the integration range like this, the second term of (equation 2) becomes one corresponding to the number of photons generated by the reflection of the excitation light by the subject sample, that is to say, one obtained by subtracting the photons generated by photoluminescence due to the excitation light from all photons generated from the subject sample. The actual spectrum measured value is generally obtained as digital data divided by a finite bandwidth with respect to $\lambda$, so that the integration of (equation 1) an (equation 2) is found by a finite sum based on the bandwidth. From the above, $\alpha q$=Nabs/N=(equation 2)/(equation 1) is found.

A method for determining the inner quantum efficiency $\eta i$ is described below. $\eta i$ is the value of the number NPL of photons generated by photoluminescence divided by the number Nabs of photons absorbed by the sample.

NPL as used herein is proportional to an amount found by (equation 3).

$$\int\lambda\cdot I(\lambda)\,d\lambda \qquad \text{(equation 3)}$$

At this time, the integration zone is limited to a wavelength region of photons generated by photoluminescence form the sample. This is for the purpose of eliminating from I($\lambda$) the contribution of photons reflected from the sample. Specifically, the lower limit of the integration of (equation 3) takes the upper end of the integration of (equation 1), and the range suitable for containing a photoluminescence-derived spectrum is taken as the upper end. For example, it is only required to take the range of 590 nm to 710 nm as the integration range in (equation 3). From the above, $\eta i$= (equation 3)/(equation 2) is found. Performing the integration from the spectrum converted to digital data is the same as the case where $\alpha q$ is determined. From the above, the emission efficiency is found by the product $\alpha q\cdot\eta i$ of the quantum absorption efficiency $\alpha q$ and the inner quantum efficiency $\eta i$.

The phosphor used in the present invention is not particularly limited, as long as it is used in a state in which the above-mentioned light emission characteristics are obtained. However, it is preferably used in a solid state, because the effect of an intermolecular interaction is large, and a flat excitation spectrum is obtained. The solid state is a crystal state, an amorphous state or a solid solution state, and particularly, it is preferred to be used as fine particles in the crystal state which are long in exciton life. As the state of use, there is a solid solution state in which the complex is dissolved in a binder resin, a dispersion state in which fine particles of the complex are dispersed in a binder resin, or the like. It is fixed in a lighting system with the binder resin, and absorbs light of an LED or the like to emit light.

The resins used therein usually include a thermoplastic resin, a thermosetting resin, a photo-curing resin and the like. Specific examples thereof include a methacrylic resin such as polymethyl methacrylate; a styrenic resin such as polystyrene or a styrene-acrylonitrile copolymer; a polycarbonate resin; a polyester resin; a phenoxy resin; a butyral resin; polyvinyl alcohol; a cellulosic resin such as ethyl cellulose, cellulose acetate or cellulose acetate butyrate; an epoxy resin; a phenol resin; a silicone resin; and the like.

The light emitting device of the present invention further has a blue phosphor and a green phosphor, together with the above-mentioned red phosphor, and a combination of these makes it possible to emit white light. For example, the blue phosphors include an inorganic phosphor such as ZuS:Ag, $Sr_5(PO_4)_3Cl$:Eu or $BaMgAl_{10}O_{17}$:Eu. Further, the green phosphors include an inorganic phosphor such as ZuS:Cu, ZnS:CuAl, $BaMgAl_{10}O_{17}$:Eu or Mn. In addition, the blue phosphors include a thulium complex, and the green phosphors include an organic phosphor such as a terbium complex. As the ligands of these complexes, there can be used known ligands, as well as the ligands of the $Eu^{3+}$ complexes used in the present invention.

White light is emitted by arranging a phosphor resin layer containing a mixture of a red phosphor, a blue phosphor and a green phosphor on a semiconductor light emitting element. In this case, the red phosphor, the blue phosphor and the green phosphor are not necessarily mixed in the same resin, and a resin layer containing the red phosphor may be laminated on a resin layer containing the blue phosphor and the green phosphor.

In the light emitting device of the present invention, the phosphor resin layer containing the red phosphor is provided on an upper portion of the semiconductor light emitting element, and the phosphor resin layer can be provided

as a contact layer between the semiconductor light emitting element and a sealing resin portion, a coating layer for the outside of the sealing resin portion, or a coating layer for the inside of an external cap. Further, it can also take a form in which the phosphor is allowed to be contained in the sealing resin portion.

In the light emitting device of the present invention, from the viewpoint of improvement in durability of the phosphor, it is preferred that a treatment for shielding ultraviolet rays of 350 nm or less is provided on the outside of the phosphor layer.

An example of the light emitting device of the present invention is shown in Fig. 3. The light emitting device 10 shown in Fig. 3 comprises a blanket 18, an outside cap 13 which covers an upper portion of the blanket 18 and is formed in a dome form, for example, from a light-permeable material such as glass, a mount lead 16b and an inner lead 16a which are attached to the blanket 18, an electric contact 19 which is attached to a lower portion of the blanket 18 and conductive to the mount lead 16b and the inner lead 16a, a semiconductor light emitting element 11 housed in a cup of an upper portion of the mount lead 16b, a sealing resin portion 17 such as an epoxy resin which is filled in the cup of the upper portion of the mount lead 16b to fix the semiconductor light emitting element 11, a phosphor layer 12 of a film in which a phosphor is mixed and dispersed in a binder resin and which is coated on the inside of the outside cap 13, an ultraviolet absorbing layer 14b formed lying between the phosphor layer 12 and the outside cap 13, a conductive wire 15a which makes the inner lead 16a and the semiconductor light emitting element 11 conductive to each other, and a conductive wire 15b which makes the semiconductor light emitting element 11 and the mount lead 16b conductive to each other. The inside of the outside cap 13 is in vacuum or filled with an inert gas 14a such as nitrogen gas or argon gas.

The semiconductor light emitting element 11 emits light in the region from near-ultraviolet light to visible light. This light is absorbed by the phosphor contained in the phosphor layer 12, thereby emitting visible light having a longer wavelength. The fluorescent complexes used in the phosphors are liable to deteriorate by light in the presence of oxygen, so that the inside of the outside cap 13 is filled with the inert gas 14a to remove oxygen, thereby improving light fastness. Instead of filling with the inert gas 14a, it is also possible to improve light fastness of the phosphor layer 12 to enhance durability of the light emitting device 10 by keeping the inside of the outside cap in a vacuum state. Oxygen is preferably removed so that the oxygen concentration in the inside of the outside cap 13 becomes 100 ppm or less, and preferably 20 ppm or less. Under such an atmosphere, light fastness of the fluorescent complex is significantly improved. Further, light fastness is also improved under low humidity.

As the semiconductor light emitting element 11 which emits light in the region from near-ultraviolet light to visible light, there is used a semiconductor laser (LD), a light emitting diode (LED) or the like. The semiconductor light emitting element 11 having a peak wavelength which is excessively on the short wavelength side has the tendency of organic compounds such as the complex and the binder resin to be liable to deteriorate. This is therefore unfavorable. Further, when the peak wavelength is excessively on the long wavelength side, light excitation energy necessary for light emission of the fluorescent complex is not obtained, so that the phosphor can not emit light. From the above-mentioned reasons, the light emission peak wavelength of the semiconductor light emitting element 11 is preferably within the range of 370 nm to 470 nm, and particularly, the LD or LED having a peak wavelength of 380 nm to 470 nm is preferred. In particular, the GaN-based LD or LED is preferred.

The phosphor layer 12 is provided in a film form formed by applying the resin composition comprising the fluorescent complex and the binder resin onto the inside of the outside cap 13. In the phosphor layer 12, it is also possible to properly use the above-mentioned fluorescent complex or inorganic phosphor together.

The light emitting devices of the present invention can be used alone or as a combination of the plurality of them, as various lighting systems or display units.

Examples

The present invention will be illustrated with reference to examples in more detail below, but the present invention should not be construed as being limited to the following examples as long as it does not exceed its gist.

Example 1

Synthesis of $Eu(TTA)_3(TPPO)_2$

0.67 g (3.0 mmol) of 4,4,4-trifluoro-1-(2-thienyl)-1,3-butanedione (H-TTA), 0.56 g (2.0 mmol) of triphenylphosphine oxide (TPPO) and 0.32 g (3.0 mmol) of 2,2'-iminodiethanol were dissolved in 40 ml of isopropanol. To this solution, a solution obtained by dissolving 0.37 g (1 mmol) of europium chloride (III) hexahydrate in 20 ml of a mixed solvent of water/isopropanol (1/4) was added dropwise at room temperature taking 2 hours, and stirring was further continued at room temperature for 1 hour. A precipitate formed was filtered by suction, and washed with water and isopropanol. The resulting light yellow powder was dried under vacuum at 50°C to obtain a desired product $Eu(TTA)_3(TPPO)_2$ represented by the following structural formula. The melting point of this complex was from 248°C to 251°C.

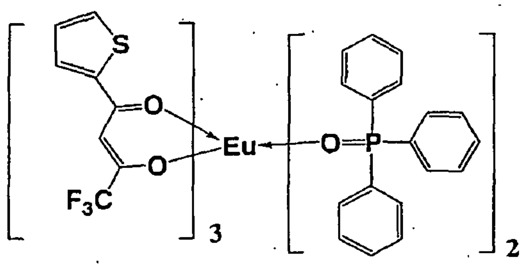

$Eu(TTA)_3(TPPO)_2$

Example 2

Synthesis of $Eu(TTA)_3Phen$

6.67 g (30 mmol) of H-TTA, 1.98 g (10 mmol) of 1,10-phenanthroline (Phen) monohydrate and 3.16 g (30 mmol) of 2,2'-iminodiethanol were dissolved in 500 ml of ethanol. To this solution, a solution obtained by dissolving 3.67 g (10 mmol) of europium chloride (III) hexahydrate in 200 ml of ethanol was added dropwise at room temperature taking 4 hours, followed by further standing at room temperature for several hours. Then, a precipitate formed was filtered by suction, and washed with ethanol. The resulting light yellow powder was dried under vacuum at 50°C to obtain a desired product $Eu(TTA)_3Phen$ represented by the following structural formula.

Elemental analysis of this complex showed 43.33% C, 2.36% H and 2.78% N, which were approximately identical to calculated values, 43.43% C, 2.02% H and 2.81% N. Further, the melting point of this complex was from 242°C to 243°C.

For the resulting Eu $(TTA)_3Phen$ complex, a powder X-ray diffraction measurement was made. A powder X-ray diffraction pattern thereof is shown in Fig. 4. As seen from Fig. 4, it was confirmed to be a crystalline compound. Further, X-ray crystal structure analysis showed the following results:

Crystal system; triclinic system
Space group; P1
Lattice constants; a=13.0 angstroms, b=15.0 angstroms, c=9.6 angstroms, $\alpha$=92.9°, $\beta$=102.8°, $\gamma$=91.5°

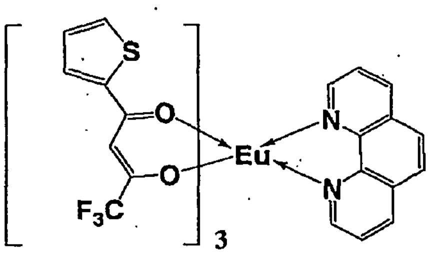

$Eu(TTA)_3Phen$

Example 3

Synthesis of $Eu(TTA)_3IQNO$

0.67 g (3 mmol) of H-TTA, 0.15 g (1 mmol) of isoquinoline-N-oxide (IQNO) and 0.32 g (3 mmol) of 2,2'-iminodiethanol were dissolved in 25 ml of ethanol. To this solution, a solution obtained by dissolving 0.37 g (10 mmol) of europium chloride (III) hexahydrate in 20 ml of ethanol was added dropwise at room temperature, and then, 15 ml of water was added, followed by stirring at room temperature for several hours. A precipitate obtained was filtered by suction, and washed with water. The resulting light yellow powder was dried under vacuum at 50°C to obtain a desired product $Eu(TTA)_3IQNO$ represented by the following structural formula. The melting point of this complex was from 249°C to 251°C.

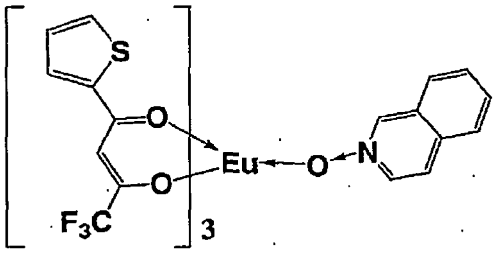

**Eu(TTA)$_3$IQNO**

Example 4

Synthesis of Eu(2MTTA)$_3$Phen

0.71 g (3.0 mmol) of 4,4,4-trifluoro-1-{5-(2-methylthienyl)}-1,3-butanedione (H-2MTTA), 0.20 g (1.0 mmol) of Phen monohydrate and 0.32 g (3.0 mmol) of 2,2'-iminodiethanol were dissolved in 30 ml of ethanol. To this solution, a solution obtained by dissolving 0.37 g (10 mmol) of europium chloride (III) hexahydrate in 20 ml of ethanol was added dropwise at room temperature taking 2 hours. Stirring was further continued for 1 hour, followed by standing at room temperature for several hours. A precipitate formed was filtered by suction, and washed with cold ethanol. The resulting light yellow powder was dried under vacuum at 50°C to obtain a desired product Eu(2MTTA)$_3$Phen represented by the following structural formula. The melting point of this complex was from 247°C to 249°C.

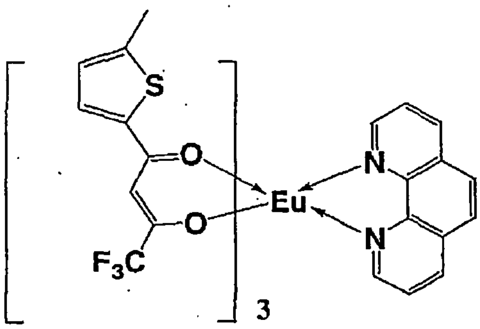

**Eu(2MTTA)$_3$Phen**

Example 5

Synthesis of Eu(2NFA)$_3$Phen

0.80 g (3.0 mmol) of 4,4,4-trifluoro-1-(2-naphthyl)-1,3-butanedione (H-2NFA), 0.20 g (1.0 mmol) of Phen monohydrate and 0.32 g (3.0 mmol) of 2,2'-iminodiethanol were dissolved in 40 ml of a mixed solvent of ethanol/isopropanol (1/2). To this solution, a solution obtained by dissolving 0.37 g (10 mmol) of europium chloride (III) hexahydrate in 20 ml of ethanol was added dropwise at room temperature taking 2 hours. Stirring was further continued for 1 hour, followed by standing at room temperature for several hours. A precipitate formed was filtered by suction, and washed with cold ethanol. The resulting light yellow powder was dried under vacuum at 80°C to obtain a desired product Eu(2NFA)$_3$Phen represented by the following structural formula. The melting point of this complex was from 216°C to 218°C.

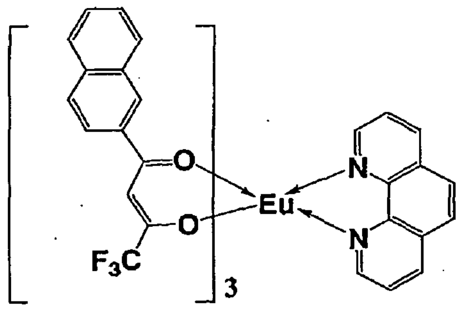

**Eu(2NFA)$_3$Phen**

Example 6

Synthesis of Eu(DBM)$_3$Phen

0.67 g (3.0 mmol) of dibenzoylmethane (H-DBM), 0.20 g (1.0 mmol) of Phen monohydrate and 0.32 g (3.0 mmol) of 2,2'-iminodiethanol were dissolved in 50 ml of ethanol. To this solution, a solution obtained by dissolving 0.37 g (10 mmol) of europium chloride (III) hexahydrate in 20 ml of ethanol was added dropwise at room temperature taking 2 hours. After stirring was further continued for 1 hour, a precipitate formed was filtered by suction, and washed with ethanol. The resulting yellow powder was dried under vacuum at 50°C to obtain a desired product Eu(DBM)$_3$Phen represented by the following structural formula. The melting point of this complex was from 171°C to 174°C.

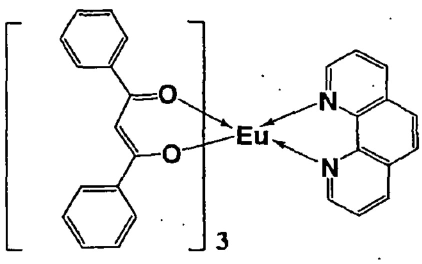

**Eu(DBM)$_3$Phen**

Example 7

Synthesis of Eu(DBM)$_3$TPPO

1.34 g (6 mmol) of H-DBM, 0.84 g (3 mmol) of TPPO and 0.63 g (6 mmol) of 2,2'-iminodiethanol were dissolved in 130 ml of a mixed solvent of isopropanol/ethanol (95/5). To this solution, a solution obtained by dissolving 0.73 g (2 mmol) of europium chloride (III) hexahydrate in 30 ml of a mixed solvent of water/isopropanol (1/1) was added dropwise at room temperature taking 3 hours, thereby slowly forming a precipitate. The precipitate formed was filtered by suction, and washed with isopropanol. The resulting yellow powder was dried under vacuum at 50°C to obtain a desired product Eu(DBM)$_3$TPPO represented by the following structural formula. The melting point of this complex was from 176°C to 177°C.

For the resulting Eu(DBM)$_3$TPPO complex, a powder X-ray diffraction measurement was made. As a result, it was confirmed to be a crystalline compound. Further, X-ray crystal structure analysis showed the following results:

Crystal system; triclinic system
Space group; P1
Lattice constants; a=12.38 angstroms, b=18.80 angstroms, c=11.55 angstroms, $\alpha$=95.68°, $\beta$=103.12°, $\gamma$=87.86°

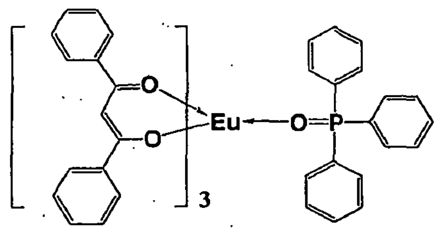

$Eu(DBM)_3TPPO$

Example 8

Synthesis of $Eu(2NFA)_3(TPPO)_2$

0.80 g (3 mmol) of H-2NFA, 0.56 g (2 mmol) of TPPO and 0.32 g (3 mmol) of 2,2'-iminodiethanol were dissolved in 40 ml of a mixed solvent of isopropanol/ethanol (7/1). To this solution, a solution obtained by dissolving 0.37 g (1 mmol) of europium chloride (III) hexahydrate in 20 ml of a mixed solvent of water/isopropanol (1/1) was added dropwise at room temperature taking 2 hours, and stirring was further continued for 1 hour, followed by standing at room temperature for several hours. A precipitate formed was filtered by suction, and washed with an isopropanol/water mixed solvent. The resulting slight orange powder was dried under vacuum at 50°C to obtain a desired product $Eu(2NFA)_3(TPPO)_2$ represented by the following structural formula. The melting point of this complex was from 86°C to 98°C.

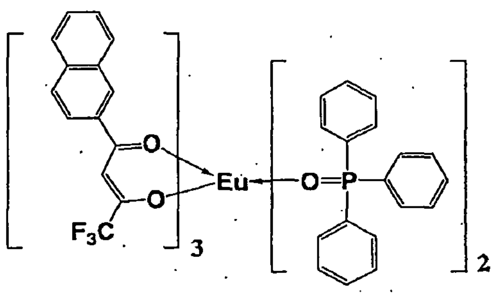

$Eu(2NFA)_3(TPPO)_2$

Example 9

Synthesis of $Eu(2NFA)_3DPPhen$

0.80 g (3 mmol) of H-2NFA, 0.33 g (1 mmol) of 4, 7-diphenyl-1, 10-phenanthroline (DPPhen) and 0.32 g (3 mmol) of 2,2'-iminodiethanol were dissolved in 20 ml of ethanol. To this solution, a solution obtained by dissolving 0.37 g (1 mmol) of europium chloride (III) hexahydrate in 20 ml of a mixed solvent of water/ethanol (1/1) was added dropwise at room temperature taking 30 minutes. A precipitate formed was filtered by suction, and washed with water. Then, the resulting slight orange powder was dried under vacuum at 50 D. After this powder was instantly heated to 130°C in a non-solvent state, a mixed solvent of ethanol/isopropanol (1/1) was added, followed by reflux in a suspended state for 30 minutes. Then, the suspension was slowly cooled to room temperature. The resulting precipitate was filtered by suction, and washed with ethanol. Thereafter, it was dried under vacuum at 50°C to obtain a desired product Eu $(2NFA)_3DPPhen$ represented by the following structural formula. The melting point of this complex was from 173°C to 176°C.

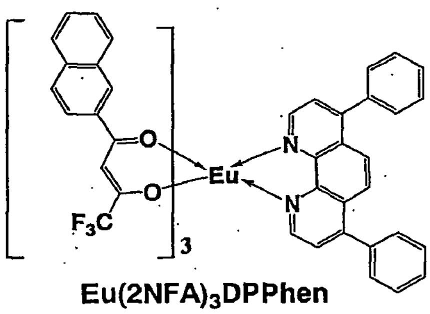

Eu(2NFA)$_3$DPPhen

Comparative Example 1

Synthesis of Eu(DBM)$_3$TPPO

1.34 g (6 mmol) of H-DBM, 0.84 g (3 mmol) of TPPO and 0.63 g (6 mmol) of 2,2'-iminodiethanol were dissolved in 80 ml of ethanol. To this solution, a solution obtained by dissolving 0.73 g (2 mmol) of europium chloride (III) hexahydrate in 20 ml of a mixed solution of water/ethanol (1/1) was added dropwise at room temperature. To the resulting yellow transparent solution, 50 ml of water was added little by little. A precipitate formed was filtered by suction, and washed with water. The resulting yellow powder was dried under vacuum at 50°C to obtain a desired product Eu(DBM)$_3$TPPO. The melting point of this complex was from 78°C to 85°C.

For the resulting Eu(DBM)$_3$TPPO complex, a powder X-ray diffraction measurement was made. As a result, no crystalline peak was observed, and it was confirmed to be an amorphous compound.

Comparative Example 2

Synthesis of Eu(TTA)$_3$Phen

13.34 g (60 mmol) of H-TTA, 3.60 g (20 mmol) of Phen and 6.32 g (60 mmol) of 2,2'-iminodiethanol were dissolved in 400 ml of ethanol. To this solution, a solution obtained by dissolving 7.33 g (20 mmol) of europium chloride (III) hexahydrate in 100 ml of ethanol was added dropwise at room temperature taking 1 hour, and stirring was further continued at room temperature for 1 hour. A precipitate formed was filtered by suction, and washed with ethanol. The resulting white powder was dried under vacuum at 50°C to obtain a desired product Eu(TTA)$_3$Phen represented by the following structural formula.

Elemental analysis of this complex showed 43.15% C, 2.32% H and 2.83% N, which were approximately identical to calculated values, 43.43% C, 2.02% H and 2.81% N. Further, the melting point of this complex was from 240°C to 242°C.

For the resulting Eu(TTA)$_3$Phen complex, a powder X-ray diffraction measurement was made. A powder X-ray diffraction pattern thereof is shown in Fig. 5. A comparison of Figs. 4 and 5 reveals that the complex is a compound different from that shown in Fig. 4 in crystal structure.

Comparative Example 3

Synthesis of Eu(2NFA)$_3$Phen

0.80 g (3.0 mmol) of H-2NFA, 0.18 g (1.0 mmol) of Phen and 0.32 g (3.0 mmol) of 2,2'-iminodiethanol were dissolved in 20 ml of ethanol. To this solution, a solution obtained by dissolving 0.37 g (10 mmol) of europium chloride (III) hexahydrate in 20 ml of a mixed solvent of ethanol/water (1/1) was added dropwise at room temperature taking 30 minutes. Stirring was further continued for 1 hour, followed by standing at room temperature for several hours. A precipitate formed was filtered by suction, and washed with water. The resulting light yellow powder was dried under vacuum at 50°C to obtain a desired product Eu(2NFA)$_3$Phen.

Elemental analysis of this complex showed 57.25% C, 2.71% H and 2.51% N, which were approximately identical to calculated values, 57.51% C, 2.86% H and 2.48% N. Further, the melting point of this complex was from 157°C to 159°C.

Comparative Example 4

Synthesis of Eu(2NFA)DPPhen

0.80 g (3 mmol) of H-2NFA, 0.33 g (1 mmol) of 4,7-diphenyl-1,10-phenanthroline (DPPhen) and 0.32 g (3 mmol) of 2, 2'-iminodiethanol were dissolved in 20 ml of ethanol. To this solution, a solution obtained by dissolving 0.37 g (1 mmol) of europium chloride (III) hexahydrate in 20 ml of a mixed solvent of water/ethanol (1/1) was added dropwise at room temperature taking 30 minutes. A precipitate formed was filtered by suction, and washed with water. Then, the resulting slight orange powder was dried under vacuum at 50°C. This powder (500 mg) was dissolved in 20 ml of ethanol under reflux, followed by cooling in an ice bath. The resulting precipitate was filtered by suction, and washed with cold ethanol. Thereafter, it was dried under vacuum at 50°C to obtain a desired product Eu(2NFA)DPPhen. The melting point of this complex was from 138°C to 150°C.

Comparative Example 5

Synthesis of $Eu(HFA)_3(TPPO)_2$

1.87 g (9 mmol) of hexafluoroacetylacetone (HFA), 1.70 g (6 mmol) of TPPO and 0.95 g (9 mol) of 2,2'-iminodiethanol were dissolved in 40 ml of isopropanol. To this solution, a solution obtained by dissolving 1.10 g (3 mmol) of europium chloride (III) hexahydrate in 20 ml of a mixed solvent of water/isopropanol (1/1) was added dropwise at room temperature taking 30 minutes. To the resulting yellow transparent solution, 20 ml of water was added little by little, and stirring was further continued at room temperature for 1 hour, followed by standing for several hours. A precipitate formed was filtered by suction, and washed with water. Then, the resulting slight orange powder was dried under vacuum at 50°C to obtain a desired product $Eu(HFA)_3(TPPO)_2$ represented by the following structural formula. The melting point of this complex was 290°C or more.

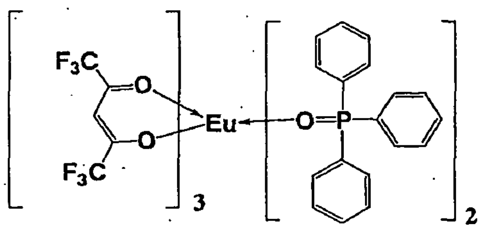

$Eu(HFA)_3(TPPO)_2$

Comparative Example 6

Synthesis of $Eu(HFA)_3DMGE$

0.62 g (3 mmol) of HFA, 0.13 g (1 mmol) of diethylene glycol dimethyl ether (DMGE) and 0.32 g (3 mmol) of 2, 2' -iminodiethanol were dissolved in 40 ml of a mixed solvent of ethanol/water (1/3). To this solution, a solution obtained by dissolving 0.37 g (1 mmol) of europium chloride (III) hexahydrate in 20 ml of water was added dropwise at room temperature taking 30 minutes, and stirring was further continued for 1 hour. A precipitate formed was filtered by suction, and washed with water. Then, the resulting white powder was dried under vacuum at 50°C to obtain a desired product $Eu(HFA)_3DMGE$ represented by the following structural formula. The melting point of this complex was from 65°C to 69°C.

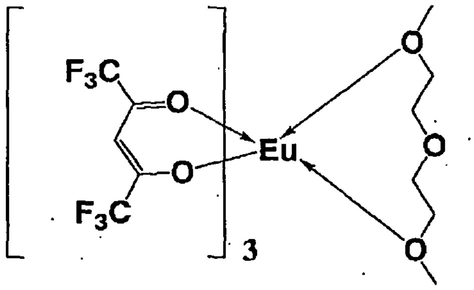

Eu(HFA)$_3$DMGE

Light emission characteristics of the red phosphors produced in the above-mentioned Examples and Comparative Examples, $La_2O_2S$:Eu (KX-681 manufactured by Kasei Optonix Ltd.) (Comparative Example 7) and $Y_2O_2S$:Eu (P22-RE3 manufactured by Kasei Optonix Ltd.) (Comparative Example 8) are shown in Table 1. In Table 1, λmax indicates an excitation wavelength showing a maximum emission intensity in an excitation spectrum, and λH and λL indicate excitation wavelengths showing a maximum emission intensity and a minimum emission intensity, respectively, within the excitation wavelength range of 380 nm to 410 nm. L/H is the ratio of the minimum emission intensity to the maximum emission intensity within the excitation wavelength range of 380 nm to 41.0 nm. The emission efficiency in 400 nm excitation was measured by the above-mentioned method.

Using $Y_2O_3$:Eu as a reference material of the phosphor, the emission efficiency in 254 nm excitation was measured by a method similar to the measuring method in the present Examples. As a result, a value of 58.5% was obtained to the literature value of 56.0% (J, Illum. Engng. Inst. Jpn, Vol. 83, No.2, 1999). From this, the value of the emission efficiency can be said to be reliable.

Fig. 3 shows excitation spectra of the phosphors of Example 6 and Comparative Example 7. It is known that the fluorescence intensity of the phosphor of Comparative Example 7 rapidly changes at an excitation wavelength of 380 nm to 410 nm, but that the fluorescence intensity of the phosphor of Example 6 little changes.

Fig. 6 shows excitation spectra of the phosphors of Example 2 and Comparative Example 2. It is known that even for the same compound, light emission characteristics are different depending on the difference in crystal structure.

Fig. 7 shows excitation spectra of the phosphors of Example 7 and Comparative Example 1. It is known that even for the same compound, light emission characteristics are different depending on the difference in crystal structure.

The phosphors of Examples have high emission efficiency and high L/H value, so that when these phosphors are used in a light emitting device in which an LED or LD having an emission peak at a wavelength of 380 nm to 410 nm is used as an excitation light source, there is obtained the light emitting device which is bright and small in changes in emission intensity caused by a deviation in wavelength of the excitation light source.

Table 1

| No. | Sample Name | $\lambda_{max}$ | λH | λL | L/H % | Emission Efficiency |
|---|---|---|---|---|---|---|
| Example 1 | Eu(TTA)$_3$(TPPO)$_2$ | 388 | 388 | 410 | 78.1 | 50.0 |
| Example 2 | Eu(TTA)$_3$Phen | 388 | 388 | 410 | 83.9 | 47.6 |
| Example 3 | Eu(TTA)$_3$IQNO | 395 | 395 | 410 | 85.7 | 54.9 |
| Example 4 | Eu(2MTTA)$_3$Phen | 390 | 390 | 410 | 81.7 | 45.0 |
| Example 5 | Eu(2NFA)$_3$Phen | 398 | 398 | 410 | 86.4 | 39.2 |
| Example 6 | Eu(DBM)$_3$Phen | 404 | 404 | 380 | 95.8 | 33.4 |
| Example 7 | Eu(DBM)$_3$TPPO | 407 | 407 | 380 | 94.8 | 41.3 |
| Example 8 | Eu(2NFA)$_3$(TPPO)$_2$ | 397 | 397 | 410 | 84.1 | 29.1 |
| Example 9 | Eu(2NFA)$_3$DPPhen | 390 | 390 | 410 | 76.2 | 37.4 |
| Comparative Example 1 | Eu(DBM)$_3$TPPO | 401 | 401 | 380 | 94.8 | 14.2 |
| Comparative Example 2 | Eu(TTA)$_3$Phen | 386 | 386 | 410 | 50.2 | 29.4 |
| Comparative Example 3 | Eu(2NFA)$_3$Phen | 388 | 388 | 410 | 53.8 | 6.8 |

(continued)

| No. | Sample Name | $\lambda_{max}$ | λH | λL | L/H % | Emission Efficiency |
|---|---|---|---|---|---|---|
| Comparative Example 4 | Eu(2NFA)$_3$DPPhen | 390 | 390 | 410 | 58.8 | 26.4 |
| Comparative Example 5 | Eu(HFA)$_3$(TPPO)$_2$ | 362 | 380 | 410 | 46.1 | 21.0 |
| Comparative Example 6 | Eu(HFA)$_3$DMGE | 360 | 380 | 410 | 67.4 | 8.0 |
| Comparative Example 7 | $La_2O_2S$:Eu | 334 | 380 | 410 | 19.6 | 16.0 |
| Comparative Example 8 | $Y_2O_2S$:Eu | 313 | 380 | 410 | 15.6 | 8.4 |

Although the present invention has been described in detail in its specific embodiments, it will be obvious to those skilled in the art that various changes and modifications are possible without departing from the spirit and scope of the invention.

The present application is based on Japanese Patent Application (Patent Application No. 2004-30173) filed on February 6, 2004, the whole of which is incorporated herein by reference.

Industrial Applicability

According to the present invention, there can be provided a light emitting device which is high in emission intensity and stable.

## Claims

**1.** A light emitting device which comprises a phosphor and a semiconductor light emitting element,
wherein the phosphor has $Eu^{3+}$ as a luminescent center ion, wherein a minimum emission intensity of the phosphor within the excitation wavelength range of 380 nm to 410 nm in an excitation spectrum is 65% or more of a maximum emission intensity, and wherein the phosphor has an emission efficiency at 400 nm of 20% or more, and
wherein the semiconductor light emitting element emits light in the region from near-ultraviolet light to visible light.

**2.** The light emitting device according to claim 1, wherein said phosphor is a phosphor having a maximum emission intensity of 3 times or more the intensity of a peak around 465 nm which is in an excitation band of the f-f transition of $Eu^{3+}$, in the excitation spectrum.

**3.** The light emitting device according to claim 1 or 2, wherein said phosphor is a fluorescent complex having $Eu^{3+}$.

**4.** The light emitting device according to claim 3, wherein said phosphor is a fluorescent complex containing an aromatic group in a ligand.

**5.** The light emitting device according to claims 1 to 4, wherein said phosphor is in a solid state.

**6.** The light emitting device according claims 1 to 5, which emits white light.

**7.** The light emitting device according to claims 1 to 6, wherein said semiconductor light emitting element is a laser diode or light emitting diode, which emits light having a peak wavelength ranging from 370 nm to 470 nm.

**8.** The light emitting device according to claims 1 to 7, wherein an ultraviolet shielding treatment is performed so that said phosphor is not irradiated with ultraviolet rays of 350 nm or less.

**9.** A lighting system which comprises the light emitting device according to claims 1 to 8.

**10.** An image display unit which comprises the light emitting device according to claims 1 to 8.

Fig. 1

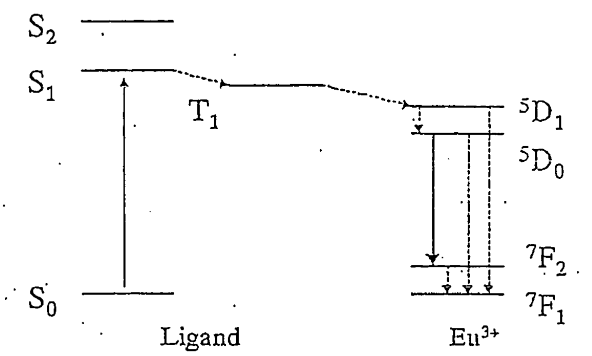
S2
S1
T1
5D1
5D0
7F2
S0
7F1
Ligand
Eu3+

Fig. 2
~~図 2~~

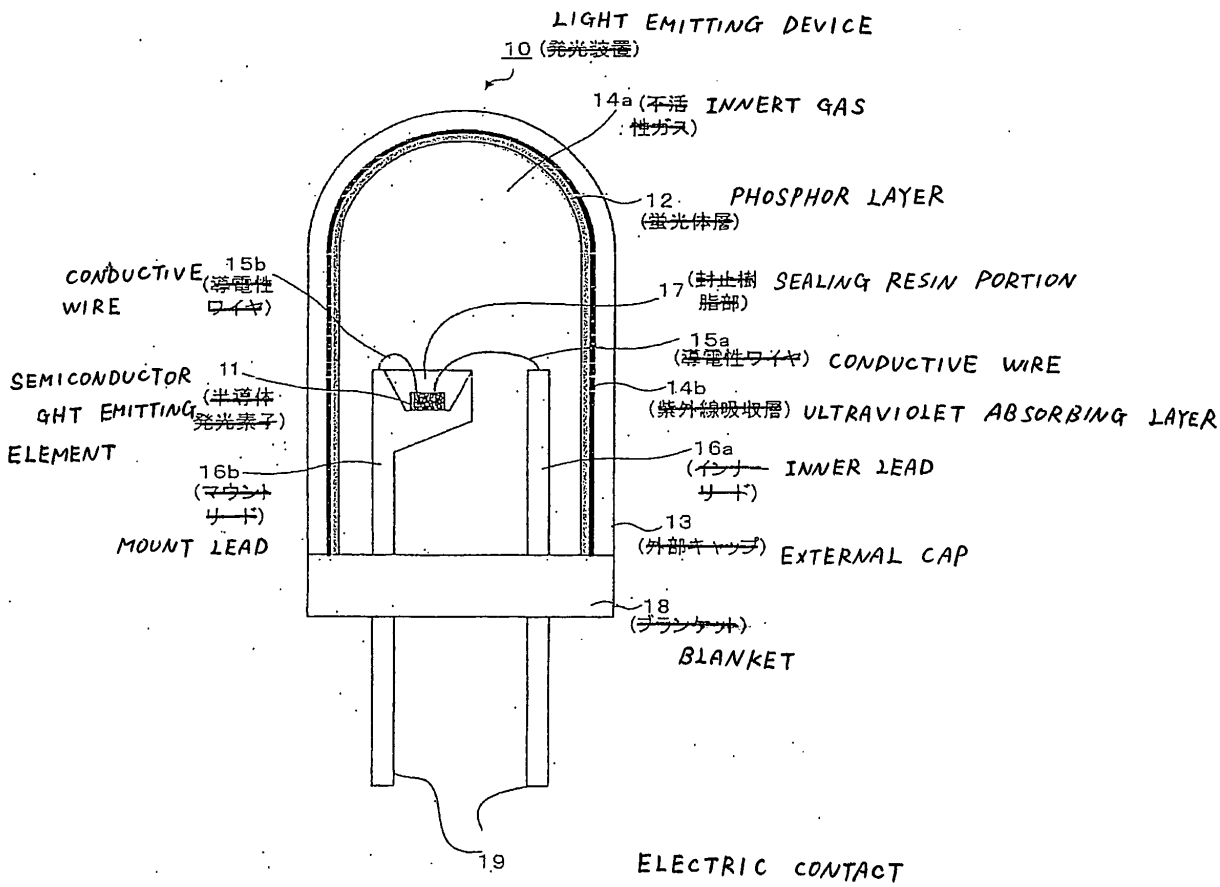
LIGHT EMITTING DEVICE
10 (発光装置)
14a (不活性ガス) INNERT GAS
12 (蛍光体層) PHOSPHOR LAYER
17 (封止樹脂部) SEALING RESIN PORTION
15a (導電性ワイヤ) CONDUCTIVE WIRE
14b (紫外線吸収層) ULTRAVIOLET ABSORBING LAYER
16a (インナーリード) INNER LEAD
13 (外部キャップ) EXTERNAL CAP
18 (ブランケット) BLANKET
19
ELECTRIC CONTACT
CONDUCTIVE WIRE 15b (導電性ワイヤ)
SEMICONDUCTOR GHT EMITTING ELEMENT 11 (半導体発光素子)
16b (マウントリード) MOUNT LEAD

Fig. 3

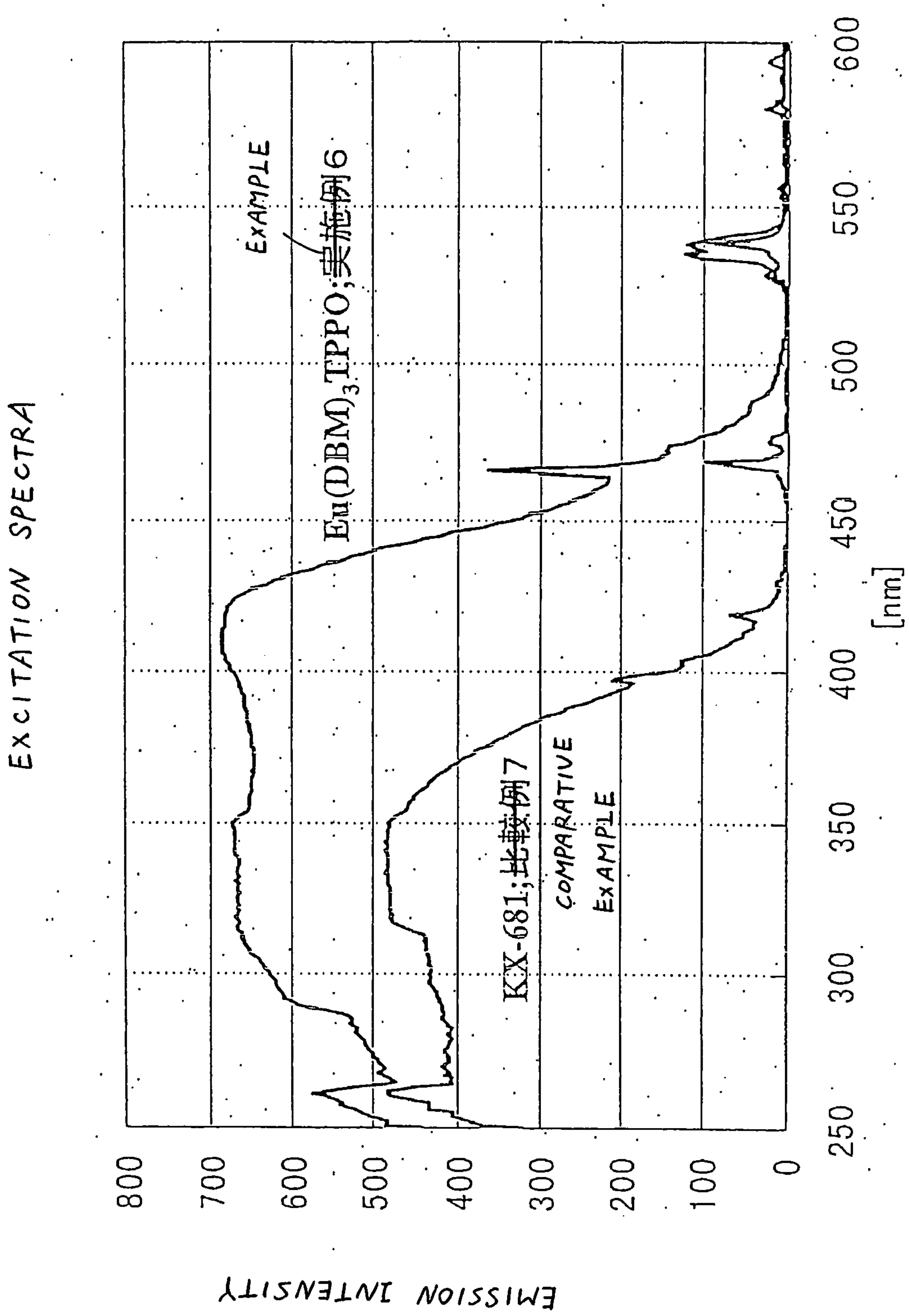
EXCITATION SPECTRA
EXAMPLE
Eu(DBM)3TPPO;実施例6
KX-681;比較例7
COMPARATIVE EXAMPLE
EMISSION INTENSITY
[nm]
0
100
200
300
400
500
600
700
800
250
300
350
400
450
500
550
600

Fig. 4

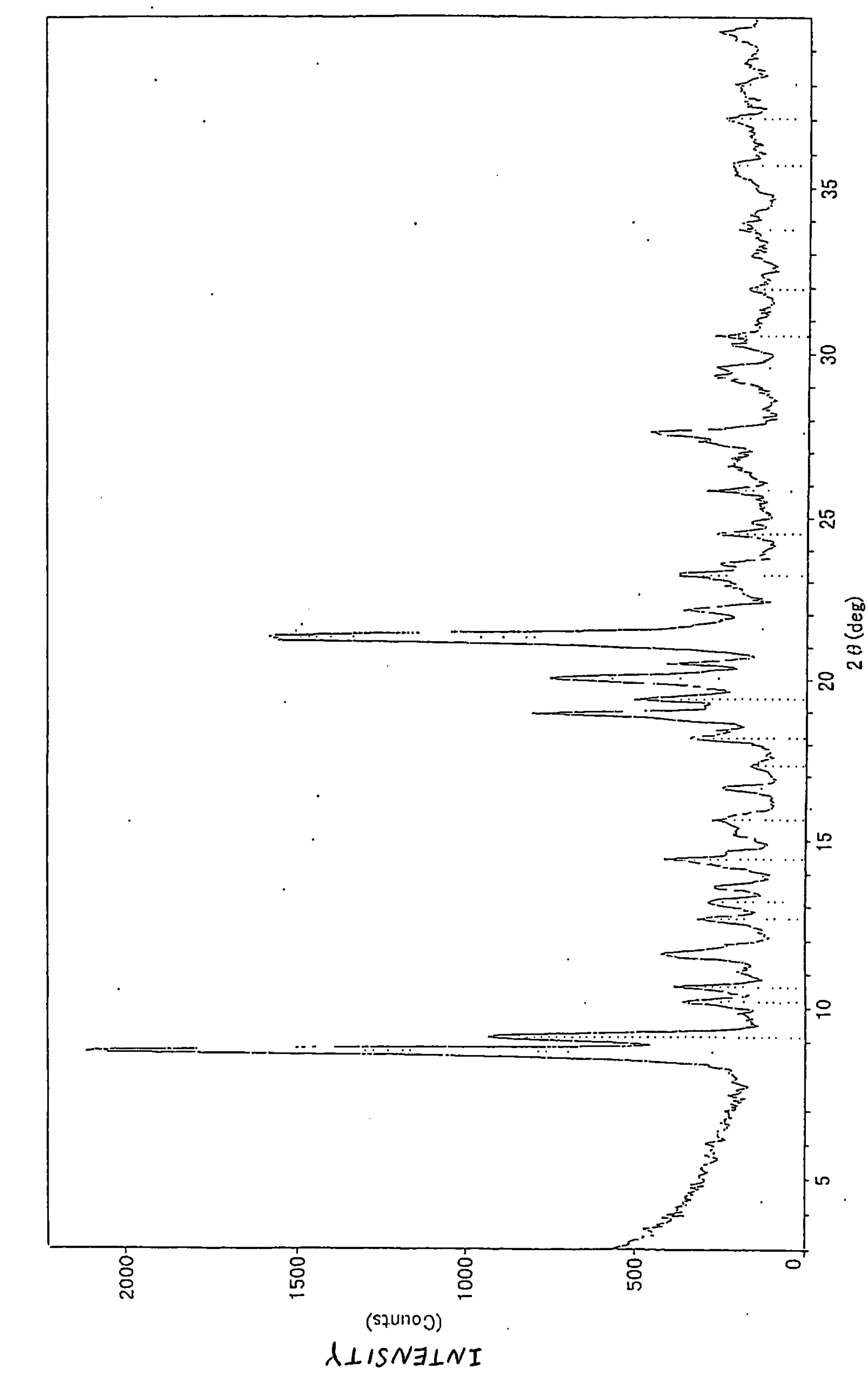


Fig. 4

Fig. 5

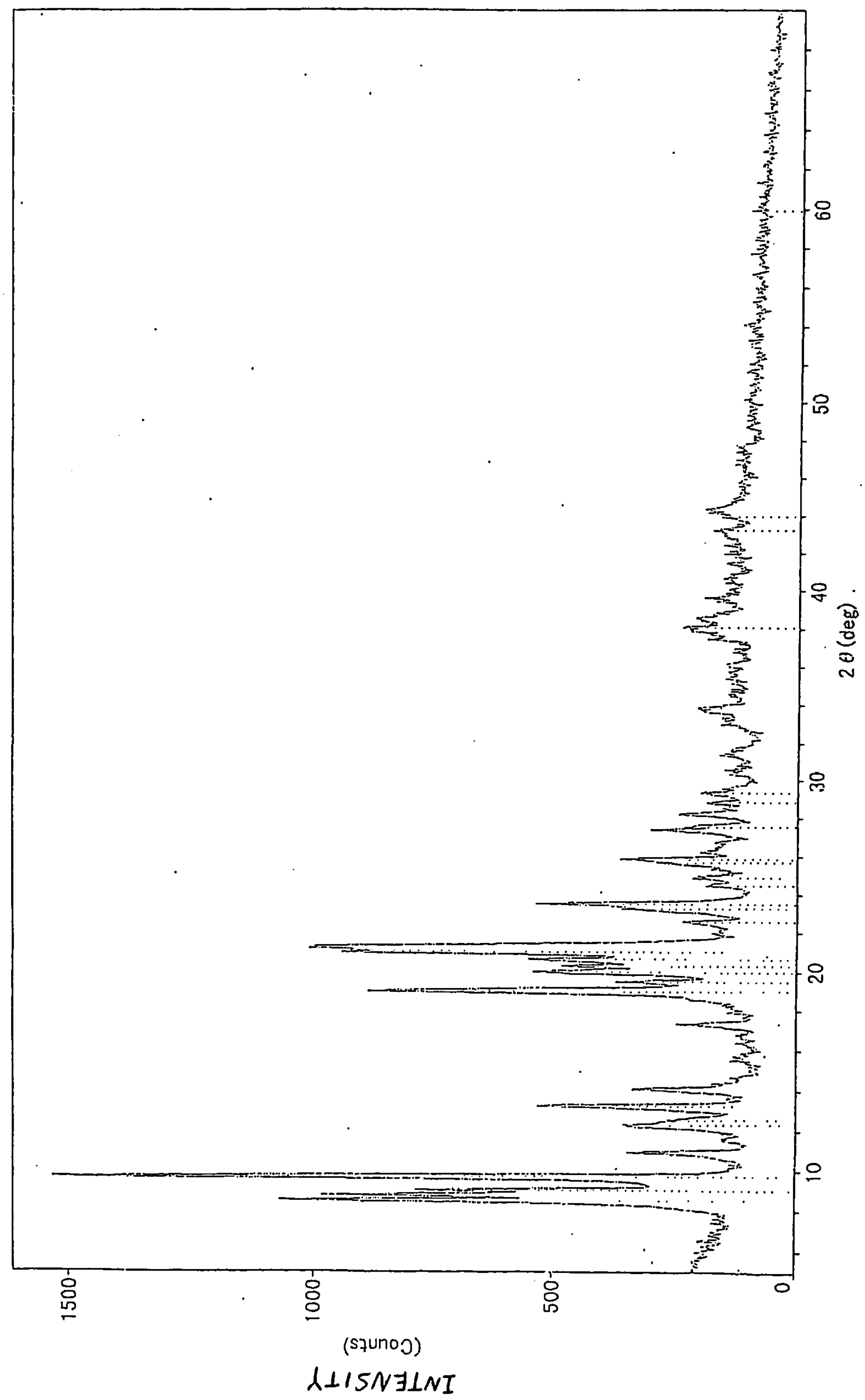

Fig. 6.

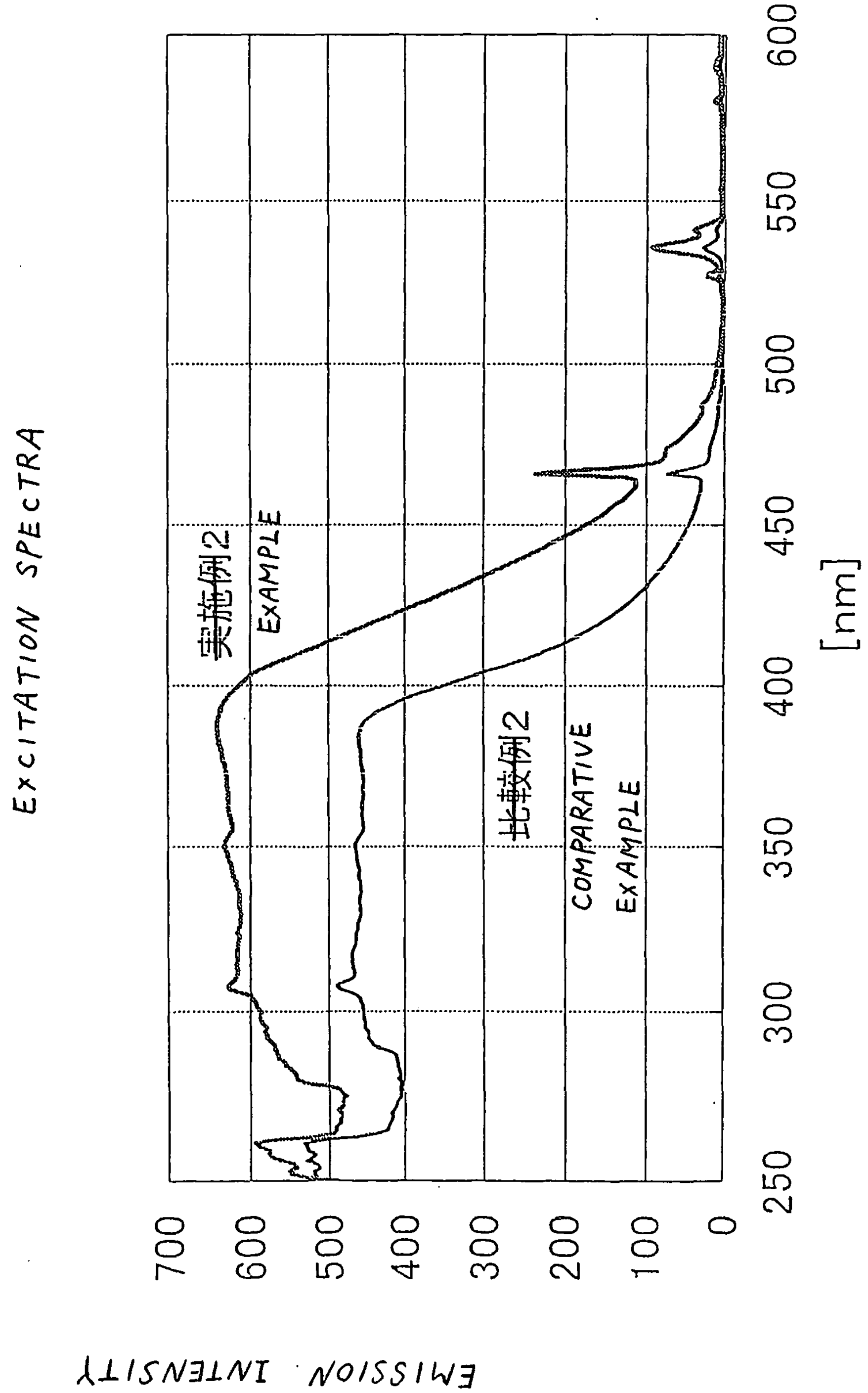
EXCITATION SPECTRA
実施例2
EXAMPLE
比較例2
COMPARATIVE EXAMPLE
700
600
500
400
300
200
100
0
250
300
350
400
450
500
550
600
[nm]
EMISSION INTENSITY

Fig. 7

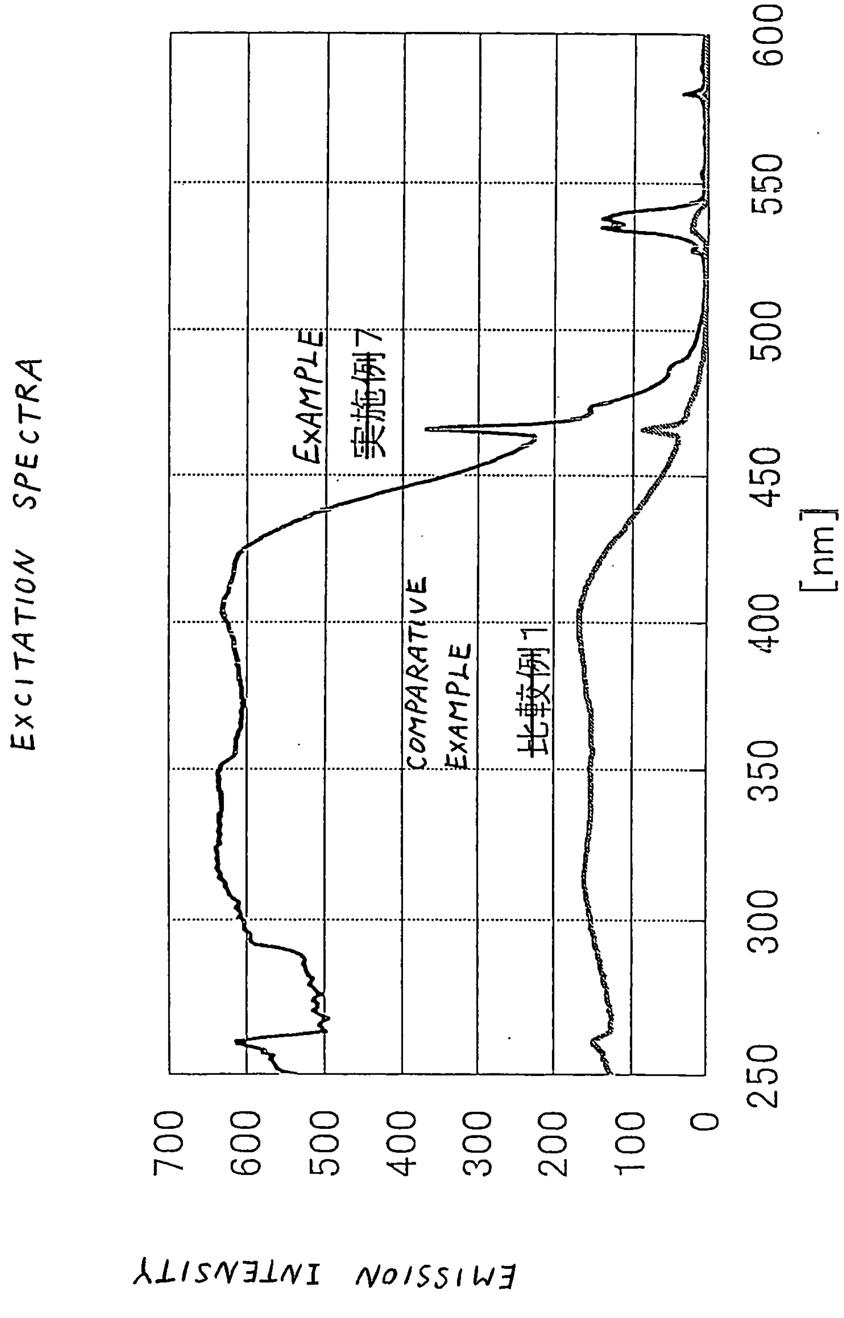
EXCITATION SPECTRA
EXAMPLE
実施例7
COMPARATIVE EXAMPLE
比較例1
EMISSION INTENSITY
700
600
500
400
300
200
100
0
250
300
350
400
450
500
550
600
[nm]

**INTERNATIONAL SEARCH REPORT**

International application No.
PCT/JP2005/002092

A. CLASSIFICATION OF SUBJECT MATTER
Int.Cl$^7$ C09K11/06, H01L33/00

According to International Patent Classification (IPC) or to both national classification and IPC

B. FIELDS SEARCHED

Minimum documentation searched (classification system followed by classification symbols)
Int.Cl$^7$ C09K11/06, H01L33/00

Documentation searched other than minimum documentation to the extent that such documents are included in the fields searched

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2002/033022 A1 (General Electric Co.), 25 April, 2002 (25.04.02), & US 6366033 B1 & EP 1334162 A1 & JP 2004-511647 A | 1-10 |
| Y | JP 2004-39297 A (Fuji Photo Film Co., Ltd.), 05 February, 2004 (05.02.04), Claims; Par. Nos. [0001] to [0005], [0025] (Family: none) | 1-10 |
| Y | JP 2001-214159 A (Semiconductor Energy Laboratory Co., Ltd.), 07 August, 2001 (07.08.01), & US 6641933 B1 & EP 1087448 A2 | 1-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 April, 2005 (06.04.05) | 26 April, 2005 (26.04.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.
PCT/JP2005/002092

C (Continuation). DOCUMENTS CONSIDERED TO BE RELEVANT

| Category* | Citation of document, with indication, where appropriate, of the relevant passages | Relevant to claim No. |
|---|---|---|
| A | WO 02/091487 A1 (Kansai TLO Kabushiki Kaisha), 14 November, 2002 (14.11.02), & US 2004/0137265 A | 1-10 |
| A | JP 2003-147346 A (Kansai TLO Kabushiki Kaisha), 21 May, 2003 (21.05.03), & WO 03/042325 A1 | 1-10 |
| A | JP 2003-81986 A (Kansai TLO Kabushiki Kaisha), 19 March, 2003 (19.03.03), & WO 03/022857 A1 | 1-10 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003004152 A
- WO 0291487 A
- JP 2003081986 A
- US 6366033 B1
- JP 2004030173 A


### Non-patent literature cited in the description


- **SUSUMU SATO ; MASANOBU WADA.** *Bulletin of The Chemical Society of Japan,* 1970, vol. 43, 1955-1962
- *J, Illum. Engng. Inst. Jpn,* 1999, vol. 83 (2